# EUROPEAN PATENT APPLICATION

(11) **EP 1 489 531 A1**
(43) Date of publication of application: **22.12.2004**
(21) Application number: 03013928.1
(22) Date of filing: 20.06.2003
(51) Int. Cl.: G06F 17/50, G06F 15/78

(54) **Simulation system and computer-implemented method for simulation and verifying a control system**

(71) Applicant: ROBERT BOSCH GMBH, 70442 Stuttgart (DE)
(72) Inventor: Weiss, Guenther, 71706 Markgroeningen (DE); Strehl, Karsten, 70376 Stuttgart (DE); Honekamp, Uwe, 70565 Stuttgart (DE)

(57) **Abstract**

A simulation system (30) for computer-implemented simulation and verification of a control system under development, the simulation system (30) comprising a plurality of simulation processes with corresponding memory and interface modules (2a-2k, 3a, 3b, 4, 6), which modules (2a-2k, 3a, 3b, 4, 6) comprise distinct memory locations for inter-module communication.

## Description

The present invention relates to a simulation system for computer-implemented simulation and verification of a control system under development as well as a computer-implemented method for simulating and verifying a control system under development. More particularly, the present invention relates to the so-called rapid prototyping of a control system for dynamic systems such as vehicles, aircrafts, ships, etc. as well as parts thereof. Further, the present invention relates to a computer program product with a computer-readable medium and a computer program stored on the computer-readable medium with program coding means which are suitable for carrying out such a process when the computer program is run on a computer.

### State of the Art

Rapid prototyping of control systems is commonly used in the automotive industry, aviation, etc. for early verification of the correct functional and real-time behavior of a control system under development. Like this, control strategies and algorithms for dynamic systems such as vehicles or parts thereof can be tested under real-world conditions without requiring the existence of the final implementation of the control loop.

A rapid prototyping system usually is characterized as being a hybrid hardware/software system, in general consisting of the following main components:
- a simulation target, consisting of one or several simulation processors with corresponding memory modules, each running basically a portion of a model of the control system under development,
- input interfaces composed of signals being fed by the plant (the outside world being controlled),
- output interfaces composed of signals feeding the plant, and
- communication interfaces for downloading the module from a host (often a personal computer) onto the simulation target, controlling the simulation experiment (start and stop commands, etc.), measuring and calibrating module signals and parameters, respectively.

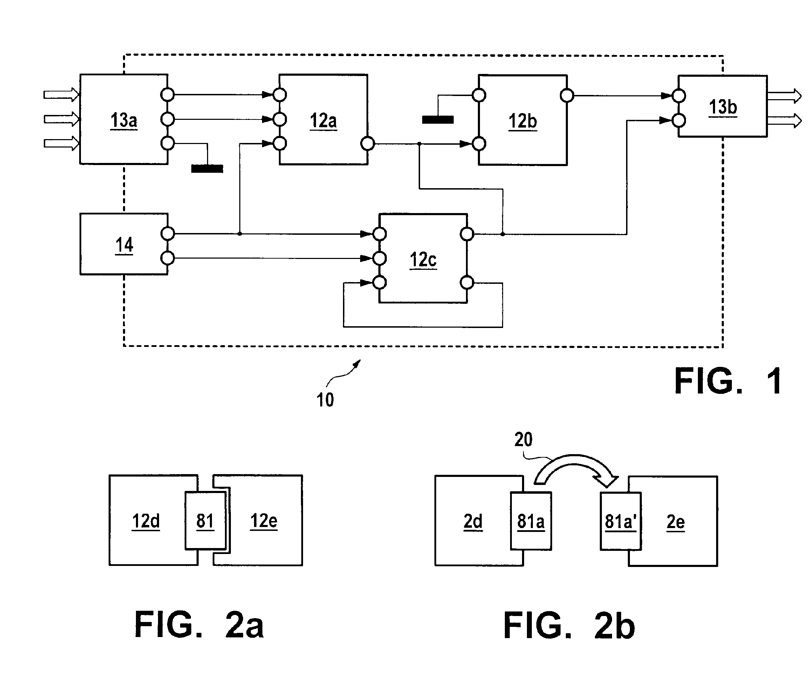

Figure 1 shows a conventional simulation system 10 as known from the prior art. The known simulation system 10 comprises one or more simulation processors with corresponding memory modules 12a, 12b, 12c on which portions of a model of the control system under development (or so-called sub-models) are run. The simulation system 10 further comprises an input interface 13a and an output interface 13b for exchanging signals with the so-called outside world. Finally, the simulation system 10 comprises a communication interface 14 for downloading the module from a host onto the simulation target, controlling the simulation experiment, measuring and calibrating module signals and parameters, respectively.

Signals of the input and output interfaces can be analog (e.g., temperature or pressure sensor) or digital (e.g., communication protocol such as CAN). Within simulation experiments, the rapid prototyping system is used as integral part of the control loop, just the way finally the controller (electronic control unit) will be.

The preparation of a rapid prototyping experiment in general consists of the following steps:
1. creation of a mathematical model of the control system, for instance, by means of a behavioral modeling tool (such as MATLAB®/Simulink®¹ or ASCET-SD²) or by hand,
2. manual transformation (hand coding) or automated transformation (code generation) of the model into program code in some high-level programming language (C, for instance),
3. compilation and linkage of the program code into an executable,
4. download of the executable from the host onto the simulation target via the host-target communication interface, and
5. setup and invocation of the experiment from the host via the communication interface.

Frequently, several model parts (called modules in the following) from one or several sources (e.g., behavioral modeling tool, hand-written C code) are to be integrated with each other, so as to compose an entire control system's model. The communication among modules 12a, 12b, 12c as well as between modules and input or output interfaces 13a, 13b (likewise considered as modules in the following) is performed via signals connecting input and output ports, depicted as circles in Figure 1.

Conventionally, this communication is achieved by sharing the very same memory location (the same high-level language variable) for ports being connected with each other, where one module writes the current value of the signal into the given memory location and the other module reads from it.

In order to achieve this, the transformation of the model into executable code needs to be performed in a manner depending on the actual interconnection scheme, denoting that output port *a* of module *A* be connected with input port *b* of module *B*, for instance. In this example, both ports *a* and *b* would need to be statically mapped onto the very same memory location on the simulation target so as to enable inter-module communication.

With this conventional static interconnection approach, signals connect ports with each other in an inseparable manner. Whenever one or several connections between signals are to be established, modified or cut off, the entire process of model-to-code transformation, compilation and linkage, executable download, experiment setup and invocation needs to be performed. For real-world models, this process is very time consuming and may take up to several tens of minutes or even more. Especially when correcting a faulty connection being made inadvertently, current turn-around times are far too large. Further, as soon as the experiment has been downloaded and started, connections cannot be altered, added, or removed any longer.

The conventional approach to date is known to be employed by rapid prototyping systems such as those of ETAS GmbH (ASCET-SD product family), The Mathworks, Inc. (MATLAB®/Simulink®, Real-Time Workshop®, xPC Target) and presumably others.

Such a static interconnection as known from the prior art is visualized in Figure 2a. Figure 2a shows a first module 12d and a second module 12e which are sharing a variable which is stored in a static memory location 81.

It is therefore an object of the invention to provide more flexible interconnection of hitherto static connections so that a simulation already being performed can be easily corrected, intercepted or modified. It is a further object of the present invention to improve communication between single components of a simulation systems as well as communication between single modules of a simulation model for providing a rapid prototyping of a control system of a vehicle.

These objects are achieved by proposing a simulation system with the features of claim 1 and a computer-implemented method for simulating and verifying a control system with the features of claim 11.

### Advantages of the invention

In contrast to the approach according to the prior art as described above, the dynamic interconnection approach of the present invention does not rely on interconnection scheme specific model-to-code transformation. Instead, this transformation is totally independent of the actual module interconnections being used. Rather, inter-module communication is performed in an explicit manner by using distinct memory locations instead of shared ones and copying or replicating signal values from one memory location to another when needed.

Since the interconnection scheme is not reflected by the mere simulation executable, it needs to be passed on to the simulation target differently. This is achieved by dynamically setting up the actual module interconnections via the host-target communication interface during experiment setup, after having downloaded the executable.

The exchange of signal values will be performed according to the respective interconnection scheme. No implicit naming conventions or the like as with the static memory sharing approach are required. Rather, the current value of a given signal is distributed from an output port to any connected input port by explicitly reading the value from the memory location associated with the output port and then replicating it to any memory location corresponding to a relevant input port.

The major advantages of this approach are:
- The turn-around times after altering the interconnection scheme are reduced significantly since the time consuming process of model-to-code transformation, compilation and linkage, and executable download needs not be repeated. This strongly supports the actual application of rapid prototyping.
- Signals connecting ports can be established, modified, or removed even during a running experiment without perceptible delay. This enables completely new possibilities of use such as the following:
   - correcting faulty connections on the fly, even without interrupting the experiment,
   - gradually setting up an experiment by putting portions of the entire model into operation little by little while continually establishing the final interconnection scheme,
   - spontaneously stimulating the model by establishing connections to its input ports,
   - switching an input port from a predefined stimulus module over to a real-world input signal,
   - comparing a number of implementation variants of the same module running in parallel by alternatively switching their outputs to the plant, or
   - swapping inputs or outputs to the rapid prototyping system virtually on the tool level, instead of first pulling out and again plugging in physical cable connections.

Therefore, according to the invention a simulation model is run to simulate and verify a control system during development, the simulation model comprises a number of sub-models which are run on respective modules of a simulation system. Communication between the respective modules of the simulation model as well as the simulation system is performed via distinct and separate memory locations, the modules being dynamically reconfigured with each other.

In a preferred embodiment of the invention, the data and/or signals are replicated consistently by means of a cross-bar switch. Preferably, this replication is performed under real time conditions.

In a further embodiment of the invention, the modules interconnect automatically via interconnection nodes and replicate data.

A consistent replication of data under real-time circumstances or conditions may be done via communication variables. The cross-bar switch as mentioned above provides means for consistently copying values of output signals to communication variables after reaching a consistent state. Further, the cross-bar switch provides means for consistently passing these values to connected input signals before the respective modules continue computation. Depending on the respective real time architecture of the simulation system and/or the set-up of the real-time operating system a consistent copy mechanism may be achieved by atomic copy processes, blocking interrupts or the like. Under certain circumstances being determined by the respective real-time environment settings, signal variables or communication variables may be obsolete and then could be optimized away for higher proformance.

According to an alternative embodiment of the invention, a distributed approach could be used for dynamic reconfiguration of module interconnections instead of the central approach as described above. In this alternative embodiment, ports could connect themselves to their respective counterparts and be responsible for signal value replication.

The invention also covers a computer program with program coding means which are suitable for carrying out a process according to the invention as subscribed above when the computer program is run on a computer. The computer program itself as well as stored on a computer-readable medium is claimed.

Further features and embodiments of the invention will become apparent from the description and the accompanying drawings.

It will be understood that the features mentioned above and those described hereinafter can be used not only in the combination specified but also in other combinations or on their own, without departing from the scope of the present invention.

The invention is schematically illustrated in the drawings by means of an embodiment by way of example and is hereinafter explained in detail with reference to the drawings. It is understood that the description is in no way limiting on the scope of the present invention and is merely an illustration of a preferred embodiment of the invention.

### Brief description of the drawings

In the drawings,
- Figure 1: is a schematic block illustration of a simulation system of the prior art;
- Figure 2a: is schematic illustration of a static interconnection of the prior art;
- Figure 2b: is a preferred embodiment of a dynamic interconnection according to the present invention;
- Figure 3: is a preferred embodiment of a simulation system according to the invention using a dynamic interconnection according to Figure 2b;
- Figure 4: is an example of a consistent replication under real-time circumstances via communication variables according to the invention; and
- Figure 5: is an alternative embodiment of an interconnection scheme according to the invention.

### Preferred embodiment

According to the invention and in contrast to the static connection known from the prior art as described above with reference to Figure 2a, a dynamic interconnection approach via distinct memory locations is provided. The principles of the dynamic interconnection according to the invention is visualized in Figure 2b wherein data 81a of a first module 2d are copied or replicated by means of dynamic replication 20 in a distinct memory location of a second module 2e as according data 81a'.

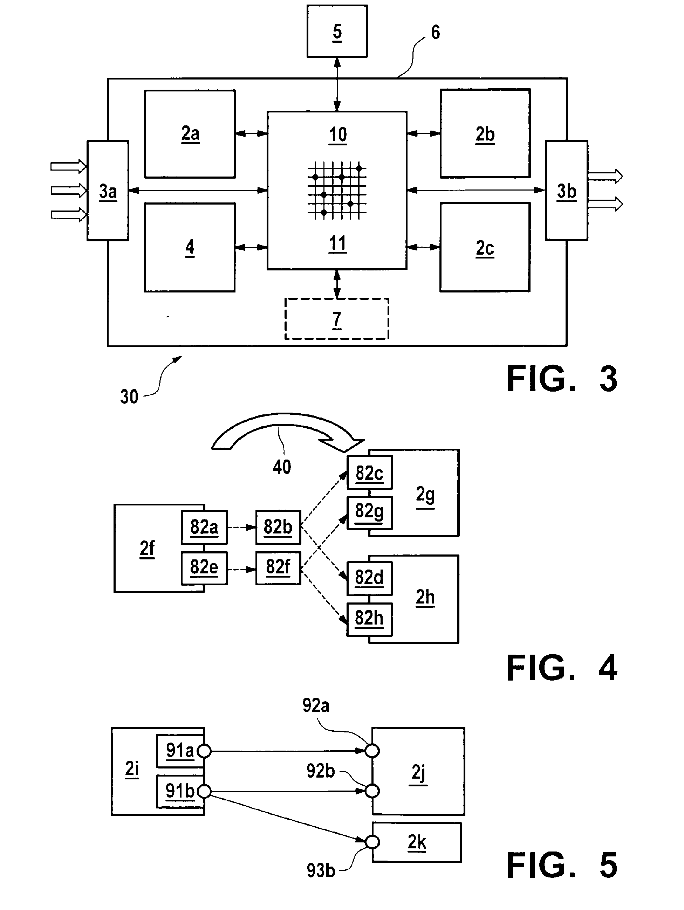

Several architectures underlying the dynamic reconfiguration approach may be conceived. With reference to Figure 3, a first example for a simulation system 30 according to the invention is described in the following as the so-called central approach.

The main component of the central approach simulation system 30 is a so-called cross-bar switch 10 with an interconnection scheme 11. The simulation system 30 further comprises a plurality of modules 2a, 2b, 2c, an input interface 3a, an output interface 3b, a stimuli generator module 4 as well as a real-time operating system 7.

As visualized by the double headed arrows in Figure 3, all components of simulation system 30 are interconnected with each other via the cross-bar switch, the interconnection scheme 11 defining which input and output ports of modules on the simulation target are connected with each other. The interconnection scheme corresponds to the totality of connections in a block diagram wherein each block corresponds to one of the modules being integrated on the simulation target 30.

The interconnection scheme 11 could be conceived as a two-dimensional switch matrix wherein both dimensions denote the modules' ports and the matrix values define whether the respective ports are connected with each other (and possibly the signal flow direction).

A simulation host 5 is connected with the cross-bar switch 10 via a host-target communication interface 6 and constitutes the human-machine interface to the rapid prototyping system.

The host 5 enables the configuration and reconfiguration of the interconnection scheme, preferably supported by some graphical user interface.

The host-target communication interface 6 connects the simulation host 5 with the simulation target 30. In general, it is based on some wired or wireless connection (serial interface, Ethernet, Bluetooth, etc.) and standardized or proprietary communication protocols (e.g., ASAP1b, L1). It provides at least the following functionality:
- download of the simulation executable from the host 5 to the simulation target 30 and
- download of configuration data defining the interconnection scheme 11.

Further, it may provide functionality for
- controlling the experiment, e.g. for starting and stopping the simulation,
- measuring values of model signals, interconnection signals, and input or output signals,
- calibrating model parameters, etc.

The cross-bar switch 10 runs on the simulation target and is connected with
- the simulation host 5 via the host-target communication interface 6,
- modules 2a, 2b, 2c representing model portions or sub-models of the control system under development,
- modules 3a, 3b representing input and output interfaces to the control system's plant,
- modules 4 serving as stimuli generators to the model, and
- preferably a real-time operating system 7 underlying the simulation experiment.

Before starting a simulation experiment, the initial interconnection scheme 11 is downloaded from the host 5 via the host-target communication interface 6 into the cross-bar switch 10.

During a running experiment, the cross-bar switch 10 performs the actual communication among modules and components by copying signal values from output ports to input ports. The way this replication process is performed is defined by the interconnection scheme 11.

The interconnection scheme 11 can be reconfigured after interrupting or even during a running simulation. Thus, module interconnections can be altered on the fly, without perceptible delay.

Referring now to Figure 4, a preferred alternative of a transmission of signals and/or data according to the invention is illustrated. By means of dynamic replication 40, signal and/or data values 82a, 82e of a first module 2f can be buffered as communication variables 82b, 82f, respectively, in distinct memory locations. By means of further dynamic replication 40, second and third modules 2g, 2h receive respective signal and/or data values 82c, 82g and 82d, 82h, respectively.

Thus, data consistency within a real-time environment is ensured. Each module 2f, 2g, 2h may compute at e.g. a different rate or upon interrupt triggers, and data replication 40 is performed by means of communication variables 82b, 82f buffering the current signal values. Thus, the values of several output signals which as a whole constitute a valid state are guaranteed to be copied in a consistent manner such that modules being fed by these output signals may themselves rely on a valid state.

As already mentioned above, the cross-bar switch 10 provides means for
- consistently copying values of output signals to communication variables after reaching a consistent state and
- consistently passing these values to connected input signals before the respective modules continue computation.

The consistent copy mechanism as described may be achieved by atomic copy processes, blocking interrupts or the like, depending on the underlying real-time architecture and operating system.

Under certain circumstances being determined by the respective real-time environment settings, signal variables or communication variables may be obsolete and then could be optimized away for higher performance.

The above-described dynamic reconfiguration approach could be extended by signal conditioning facilities. In order to achieve this, each signal value may be influenced during inter-module communication in a pre-defined manner after reading the original value from the source memory location and before writing to the target memory location.

Possible signal conditioning operations are:
- implementation formula adaptation (e.g., scale or offset modification, saturation) or
- basic mathematical operations (e.g., sum, difference, multiplication of signals, mapping via look-up table or characteristic with interpolation, constant value).

The kind of operation being applied and the respective parameters are considered as being part of the interconnection scheme. Each of them can be configured and reconfigured in a dynamic manner, as can module interconnections. This enhancement greatly widens the usefulness of the dynamic reconfiguration approach.

Referring now to Figure 5, a distributed approach for dynamic reconfiguration of module interconnections which could be used instead of the central approach employing a distinct cross-bar switch component on the target is described. Rather than having a central component copy signal values, ports could "connect themselves" to their respective counterparts and be responsible for signal value replication.

For instance, this could be achieved by having input ports 92a, 92b and 93b of modules 2j and 2k register themselves at output port servers 91a, 91b of module 2i upon connection, each of which represents a given output port. Communication could be performed either following a pull approach (input port queries signal value) or a push approach (multi-cast of signal value, invoked by output port). Thus, the intelligence for value replication is distributed over the system's components instead of concentrating it in a central cross-bar switch component.

## Claims

1. A simulation system (30) for computer-implemented simulation and verification of a control system under development, the simulation system (30) comprising a plurality of simulation processes with corresponding memory and interface modules (2a-2k, 3a, 3b, 4, 6), which modules (2a-2k, 3a, 3b, 4, 6) comprise distinct memory locations for inter-module communication.

2. A simulation system (30) according to claim 1, wherein simulation is performed by running a control system simulation model, the simulation model comprising a number of sub-models being performed on one of the plurality of modules (2a-2k, 3a, 3b, 4, 6), respectively.

3. A simulation system (30) according to claim 1, wherein at least some of the modules (2a-2k, 3a, 3b, 4, 6) are dynamically reconfigurable for communication via distinct memory locations.

4. A simulation system (30) according to claim 3, further comprising a cross-bar switch (10) for dynamic configuration of the distinct memory locations.

5. A simulation system (30) according to claim 4, wherein the cross-bar switch (10) comprises an interconnection scheme (11) for coordination of the distinct memory locations.

6. A simulation system (30) according to one of the claims 1 to 5, comprising a host-target communication interface (6) for connection of the simulation system (30) with the simulation host (5), an input interface (3a) and an output interface (3b).

7. A simulation system (30) according to claim 1, wherein the modules (2a-2k, 3a, 3b, 4, 6) comprise at least one output port server (91a, 91b) for communication interconnection with respective output port service of other modules.

8. A computer-implemented method for simulating and verifying a control system under development by means of a simulation system (30) comprising a plurality of simulation processes with corresponding memory and interface modules (2a-2k, 3a, 3b, 4, 6), wherein inter-module communication is performed by copying signal values from one module memory location to another distinct module memory location.

9. A method according to claim 8, wherein communication between modules (2a-2k, 3a, 3b, 4, 6) is achieved by means of a cross-bar switch (10) for dynamic reconfiguration of the distinct memory locations.

10. A method according to claim 9, wherein dynamic reconfiguration of the distinct memory locations is achieved according to an interconnection scheme (11).

11. A method according to claim 8, wherein inter-module communication is achieved via output port service (91a, 91b) of the various modules (2a-2k, 3a, 3b, 4, 6).

12. A computer program with program coding means which are suitable for carrying out a method according to any one of the claims 8 to 11, one the computer program is run on a computer.

13. A computer program product with a computer-readable medium and a computer program according to claim 12 stored on the computer-readable medium.
